Europäisches Patentamt

European Patent Office

Office européen des brevets

(19)

(11) Publication number: **0 105 757**
**B1**

# EUROPEAN PATENT SPECIFICATION

(45) Date of publication of patent specification: 07.12.88

(51) Int. Cl.⁴: **G 11 C 8/00**

(21) Application number: **83305993.4**

(22) Date of filing: **03.10.83**

(54) Asynchronous semiconductor memory device.

(30) Priority: **04.10.82 JP 174287/82**

(43) Date of publication of application:
**18.04.84 Bulletin 84/16**

(45) Publication of the grant of the patent:
**07.12.88 Bulletin 88/49**

(84) Designated Contracting States:
**DE FR GB**

(56) References cited:
**GB-A-2 092 851**
**US-A-4 338 679**

**PATENTS ABSTRACTS OF JAPAN, vol. 2, no.
150, December 15, 1978, page 9468 E 78; & JP -
A - 53 117 342 (NIPPON DENKI K.K.) 13-10-1978**

(73) Proprietor: **FUJITSU LIMITED
1015, Kamikodanaka Nakahara-ku
Kawasaki-shi Kanagawa 211 (JP)**

(72) Inventor: **Aoyama, Keizo
Fujitsu Limited, Patent Dpt. 1015, Kamikodanaka
Nakahara-ku Kawasaki-shi Kanagawa. 211 (JP)**
Inventor: **Agatsuma, Kenji
Fujitsu Limited, Patent Dpt. 1015, Kamikodanaka
Nakahara-ku Kawasaki-shi Kanagawa. 211 (JP)**
Inventor: **Suzuki, Yasuaki
Fujitsu Limited, Patent Dpt. 1015, Kamikodanaka
Nakahara-ku Kawasaki-shi Kanagawa. 211 (JP)**

(74) Representative: **Sunderland, James Harry et al
HASELTINE LAKE & CO Hazlitt House
28 Southampton Buildings Chancery Lane
London WC2A 1AT (GB)**

Courier Press, Leamington Spa, England.

## Description

This invention relates to an asynchronous semiconductor memory device.

An asynchronous semiconductor memory device is not restricted as regards the input timing of address information and operates immediately in response to a change in an external input address signal.

When a semiconductor memory device is mounted on a printed circuit board, the rising times and falling times of respective signals on a plurality of address signal lines connected to a semiconductor memory device suffer dispersion as a result of wiring capacitances on the printed circuit board. If signals on the plurality of address signal lines change in a scattered fashion, with different timings, the following problem occurs.

For example, when a microprocessor connected to a semiconductor memory device changes address information for the memory device from "a" to "b", unwanted address information "c" is generated because of differences in timing of changes of individual address signals.

Since an asynchronous semiconductor memory device operates immediately in response to a change of address information as explained above, it responds to the unwanted address information "c" and internal circuits of the memory commence a memory cell selecting operation in correspondence to the address information "c". Since the address information "c" should be generated only over a short period of time, the selecting operation for a memory cell corresponding to address information "b" is started before data from a memory cell corresponding to address information "c" is transmitted to an output buffer, and thus erroneous data is not output, but since the condition of the internal circuits of the memory has been caused to change, power is unnecessarily consumed as a result of generation of unwanted address information "c". Such unnecessary power consumption also occurs when noise is imposed on the adderss signal lines.

JP—A—53 117 342 (and Patent Abstracts of Japan, Vol. 2, No. 150, December 15, 1978, page 9468E78) discloses an asynchronous semiconductor memory device, having a decoder circuit arranged for receiving an address signal and operatively responsive to the address signal, comprising: a power supply line for supplying an operating voltage, the decoder circuit being arranged for receiving the operating voltage and having an output terminal for outputting a decoded output signal; a memory cell array connected to the decoder circuit for receiving the decoded output signal; and means for detecting changes of the address signal and generating detection output pulses. The output pulses from the detecting means (5, 6, 7, 81 in Fig. 3 of the document) are employed for precharging word lines of the memory cell array and to open output circuits (3 in Fig. 3 of the document).

US—A—4 338 679 discloses an arrangement in which an address transition detector also controls precharging of word lines.

GB—A—2 092 851 discloses a signal processing circuit to an arrangement in which address input transition detectors provide outputs to trigger a one shot precharge pulse for a memory.

According to the present invention there is provided an asynchronous semiconductor memory device, having a decoder circuit arranged for receiving an address signal and operatively responsive to the address signal, comprising:

a power supply line for supplying an operating voltage, the decoder circuit being arranged for receiving the operating voltage and having an output terminal for outputting a decoded output signal;

a memory cell array connected to the decoder circuit for receiving the decoded output signal; and

means for detecting changes of the address signal and generating detection output pulses, characterised in that

the detection output pulses have a predetermined pulse width corresponding to a specified period, and the memory device further comprises

holding means, for holding the decoder circuit in a not-operating condition for the specified period after a change in the address signal, the holding means including

a first transistor, connected between the power supply line and the decoder circuit, for disconnecting said decoder circuit from the power supply line for the specified period in response to a said detection output pulse, and

a second transistor, connected to the output terminal of the decoder circuit, for grounding the output terminal for the specified period in response to a said detection output pulse.

An embodiment of the present invention can provide an asynchronous semiconductor memory device in which the problems outlined above are eliminated or mitigated to afford reduced power consumption.

An embodiment of the present invention provides a semiconductor memory device which affords reduced power consumption by holding a decoder circuit thereof in a non-operative condition, in response to a change of address signal, for a specified period following the change of the address signal.

Reference is made, by way of example, to the accompanying drawings, in which:—

Fig. 1 is a schematic block diagram outlining a general asynchronous semiconductor memory device;

Fig. 2 is a schematic diagram of a decoder circuit previously employed in a memory device as shown in Fig. 1;

Fig. 3A to Fig. 3H are waveform diagrams for assistance in explaining operations of the asynchronous semiconductor memory device with decoder circuits as shown in Fig. 2,

Fig. 4 is a schematic circuit diagram of a decoder circuit employed in an asynchronous semiconductor memory device embodying this invention,

Fig. 5A to Fig. 5F are waveform diagrams for assistance in explaining operations of an asynchronous semiconductor memory device embodying this invention having decoder circuits as shown in Fig. 4,

Fig. 6 is a schematic block diagram illustrating an example of an address change detector for use with decoder circuits as shown in Fig. 4 in an embodiment of this invention;

Fig. 7 is a schematic circuit diagram illustrating an example of a pulse generator as employed in the detector of Fig. 6; and

Fig. 8 is a schematic circuit diagram of a decoder circuit employed in another embodiment of this invention.

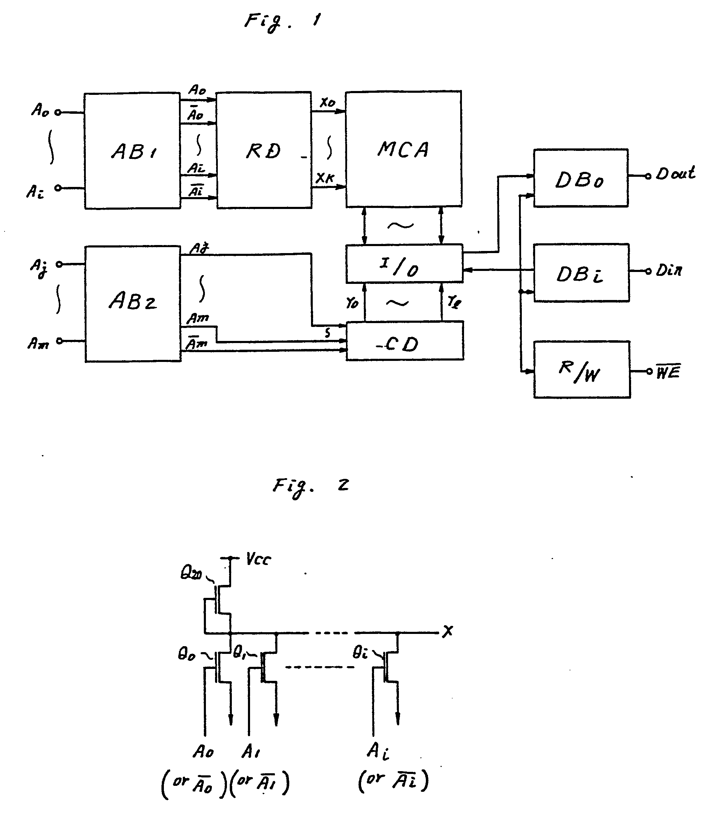

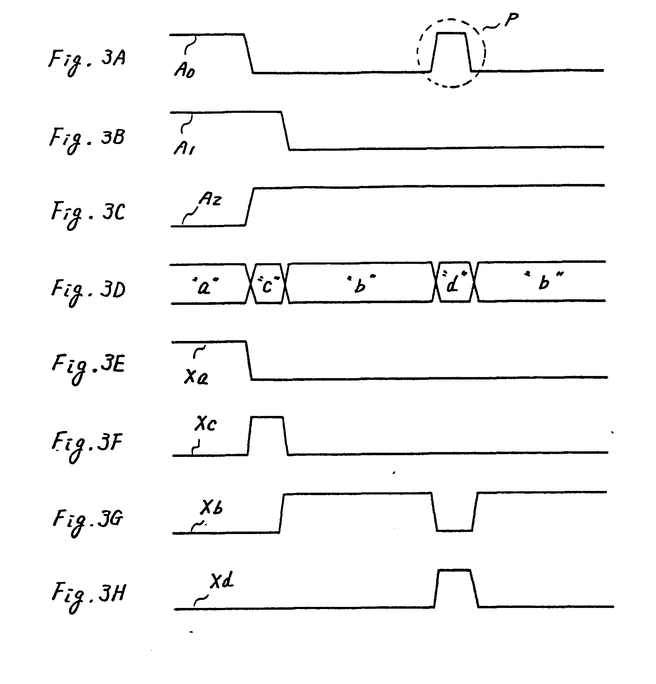

Fig. 1 is a block diagram of an ordinary asynchronous semiconductor memory device. In Fig. 1, $AB_1$, $AB_2$ are address buffers; RD is a row decoder; CD is a column decoder; MCA is memory cell array; I/O is an I/O gate; $DB_0$ is a data output buffer; $DB_i$ is a data input buffer; R/W is a read/write controller; $A_0$ to $A_l$ are row address signals; $A_j$ to $A_m$ are column address signals; $X_0$ to $X_k$ are row selection signals, $Y_0$ to $Y_l$ are column selection signals; $D_{out}$ is a data output; $D_{in}$ is a data input; and $\overline{WE}$ is a write enable signal terminal. $\overline{A}_0$ to $\overline{A}_m$ are inverse address signals.

The asynchronous semiconductor memory device of Figure 1 operates immediately to follow up a change in address signals $A_0$ to $A_m$ and performs decoding operations at the row decoder RD and the column decoder CD. A single word line (now shown) in the memory cell array MCA is selected by a row selection signal X and a single data item from a plurality of bit lines (not shown) is selected by a column selection signal Y, and the thus selected data is output through the I/O gate and the data output buffer $DB_0$.

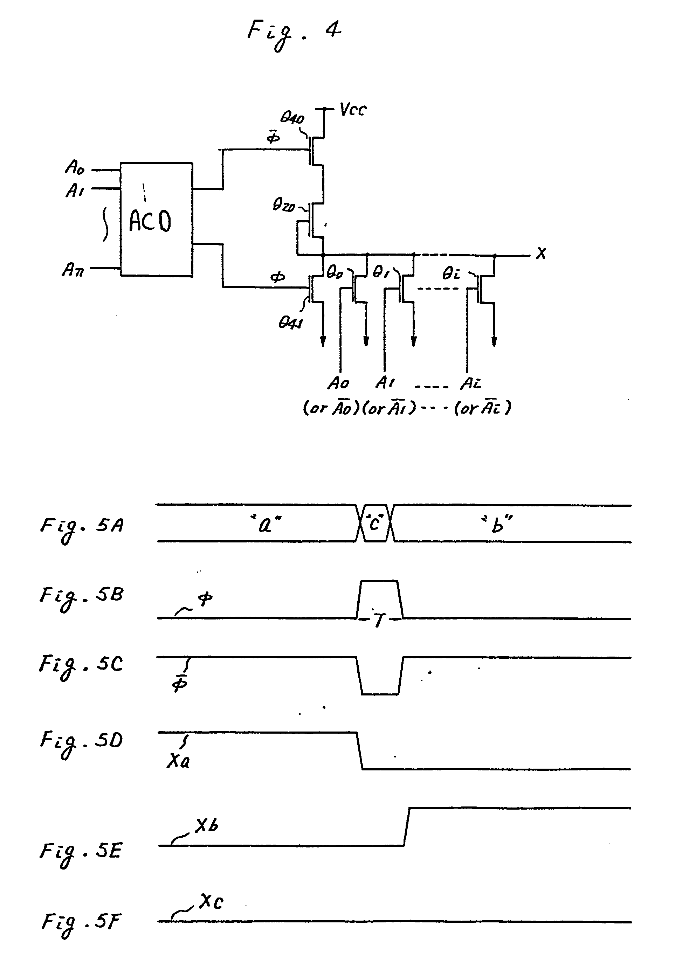

The row decoder RD of Fig. 1 comprises decoder circuits as shown in Fig. 2 equal in number to the row selection $X_0$ to $X_k$, and each deocder circuit outputs a selection signal when a specified combination of address signals is input thereto. In Fig. 2, $Q_{20}$ is a depletion type MOS transistor, $Q_0$ to $Q_l$ are enhancement type MOS transistors. When all of the address signals input to the decoder are of low level, the row selection signal X takes a high level.

The column decoder CD is formed similarly to the row decoder.

In the memory device of Fig. 1, unwanted power consumption occurs particularly in the row, column decoders in the input stage. This is explained with reference to Figs. 3A to 3H. For convenience of explanation, for Figs. 3 it will be assumed that 3-bit address signals $A_0$ to $A_2$ are input to a decoder. Fig. 3A to Fig. 3C respectively indicate the address signals $A_0$ to $A_2$, Fig. 3D indicates address data "a" to "d" provided by combinations of signals $A_0$ to $A_2$ and Fig. 3E to Fig. 3H indicate outputs $X_a$ to $X_d$ of the decoder cicuits provided in correspondence to address data "a" to "d".

When an external device connected to the memory device changes address data from an address "a" to and address "b", for example, the address signal $A_1$, for instance, changes such that in a transitional condition, an unwanted address "c" is generated and decoded. (That is, the address signal $A_1$ changes at a timing different from the change timing of address signals $A_0$ to $A_2$ as shown in Figs. 3A to 3C, resulting in transitional generation of address "c".)

When such as unwanted form of address is generated a certain decoder circuit (for address "a") operates as shown in Fig. 3E, and a certain decoder circuit (for address "b") operates as shown in Fig. 3C. However a certain decoder circuit (for address "c") operates in unwanted fashion as shown in Fig. 3F, in spite of the fact that it is unnecessary to change the output of that decoder circuit since the address "c" is an unwanted address. AC power consumption occurs in the memory device due to decoder circuit operation as shown in Fig. 3F, unnecessarily increasing power consumption.

Such power consumption also occurs when noise as indicated by P in Fig. 3A is added to an address signal line, even when an external device has not changed address bits, because in this case an unwanted address "d" as shown in Fig. 3D is generated, and an output $X_b$ of a decoder circuit (for address "b") which is not required to change, may in fact change as shown in Fig. 3G, and an output $X_d$ of a decoder circuit (for address "d") which has decoded the address "d" also changes, as shown in Fig. 3H, and unwanted power consumption occurs. When an output of decoder circuit changes, circuits connected therto in succeeding stages operate to follow up such change and unwanted power consumption also occurs therein as explained above.

An embodiment of this invention provides that such unwanted power consumption can be prevented by holding internal circuits of the memory device in a not-operating condition for responding to address signals for the specified period after change of address signal, by employing in the memory device decoder circuits as shown in Fig. 4 for instance.

The decoder circuit shown in Fig. 4 is the same as that shown in Fig. 2, except that the circuit of Fig. 4 includes enhancement type MOS transistors $Q_{40}$, $Q_{41}$ which are arranged to receive control signals $\phi$, $\overline{\phi}$ from an address change detector ACD, which transistors are connected in the circuit.

Operations of the decoder circuit of Fig. 4 are explained with reference to Fig. 5A to Fig. 5F.

Fig. 5A indicates address information; Figs. 5B and 5C indicate control signals $\phi$, $\overline{\phi}$ and Figs. 5D to 5F indicate decoder circuit outputs $X_a$, $X_b$, $X_c$ corresponding to address information "a", "b", "c", respectively.

The address signals $A_0$, $A_1$,...,$A_n$ are supplied to the address change detector ACD, and when any one of the address signals changes, control signals $\phi$ and $\overline{\phi}$ are generated for a specified period T as shown in Figs. 5B, 5C. These control signals $\overline{\phi}$ and

φ are supplied to the transistors $Q_{40}$ and $Q_{41}$ of each decoder circuit of the memory device and thereby $Q_{40}$ becomes OFF, and $Q_{41}$ becomes ON, in each decoder circuit. Therefore, all decoder circuits are separated from a power source $V_{cc}$ for a predetermined period from the change of address signal and the decoder circuit outputs are fixed at low level as shown in Figs. 5D, 5E, 5F for that period. Even when unwanted address information "c" is generated when an external device changes address information from "a" to "b", or as a result of noise, an output $X_c$ of corresponding decoder circuit does not change, as shown in Fig. 5F. Namely, an internal circuit of the memory device is held in a non-operating condition for responding to a change of address signal and unwanted power consumption an be prevented.

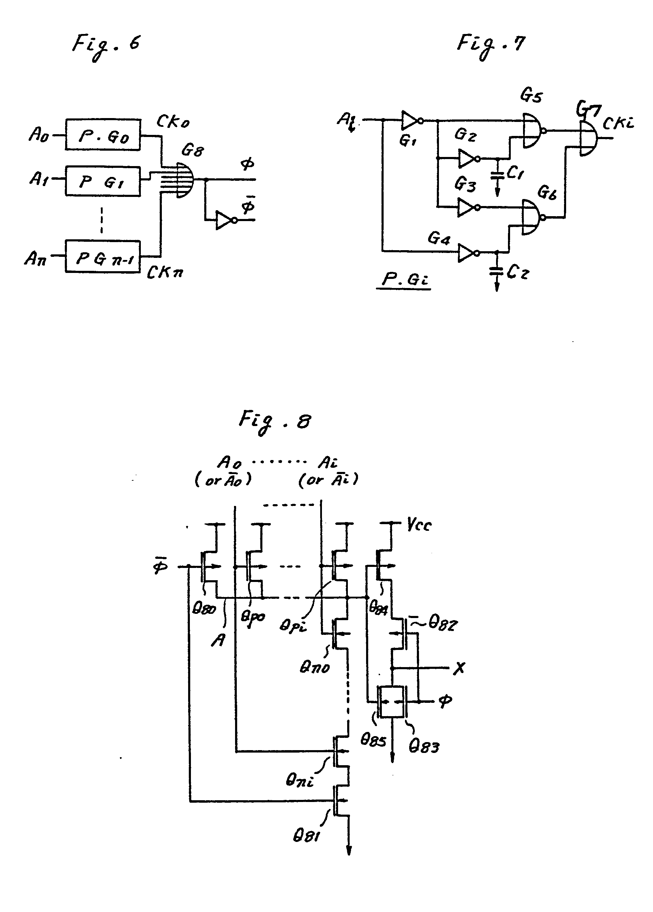

As address change detector ACD, for example, circuitry as shown in Figs. 6 and 7 may be used.

The address change comprises pulse generators $P.G_0$ to $P.G_{n-1}$ as shown in Figure 6 which receive respective address signals $A_0$ to $A_n$ to provide output signals $CK_0$ to $CK_n$ in response to a change in the received address signals. An OR gate G8 receives all the siganls $CK_0$ to $CK_n$ and provides control signal φ therefrom, with control signal $\bar{\phi}$ provided through an inverter.

Each pulse generator $P.G_i$ (i=0 to n−1) is as shown in Fig. 7, in which $G_1$ to $G_4$ are invertor gates; $G_5$, $G_6$ are NOR gates; $G_7$ is an OR gate and $C_1$ and $C_2$ are capacitors. The pulse generator circuit of Fig. 7 receives 1 bit $A_i$, of the address signals $A_0$ to $A_m$ and outputs a clock or timing signal $CK_i$ of a pulse width T when $A_i$ changes value.

When address signal $A_i$ changes from high level to low level (i.e. at the falling time of signal $A_i$) the output of the inverter $G_1$ becomes high level and the output of invertor $G_2$ is slightly delayed by the capacitor $C_1$ and becomes low level. Accordingly, NOR gate $G_6$ provides an output pulse generated at the rising time of address signal $A_i$ (and of duration determined by $C_1$). The inverters $G_3$, $G_4$, capacitor $C_2$ and NOR gate $G_6$ operates similarly, but its output is a pulse which is generated at the rising time of address signal $A_i$ (and of duration determined by $C_2$). The signals $CK_i$ is obtained by combining these signals in the OR gate $G_7$ and is a pulse (of selected duration) generated whenever address signal $A_i$ changes. An output φ, combining the outputs of a plurality of pulse genreators PG as shown in Fig. 6 by the OR gate $G_8$, provide a control signal which is generated when desired (any) address signal bit changes.

Fig. 8 illustrates a decoder circuit comprising CMOS circuits for use in another memory device embodying the present invention. In Fig. 8, $Q_{p0}$ to $Q_{pi}$ and $Q_{80}$, $Q_{82}$, $Q_{84}$ are P channel MOS transistors, $Q_{n0}$ to $Q_{ni}$ and $Q_{81}$, $Q_{83}$, $Q_{85}$ are N channel MOS transistors. In this circuit, the transistors $Q_{80}$ to $Q_{83}$ are provided to respond to control signals φ, $\bar{\phi}$. In this circuit, when $A_0$ to $A_i$ becomes high level (when the combination of address signals to which the circuit is responsive is provided, i.e. when all the address signals of the combination become high level) a decoder output X also becomes high level.

An address change is detected by an address change detector ACD as mentioned above. When the control signal φ becomes high level and $\bar{\phi}$ becomes low level, transistor $Q_{80}$ becomes ON and $Q_{81}$ becomes OFF and accordingly circuit point A in Fig. 8 is fixed to high level regardless of the supplied address information. On the other hand, $Q_{82}$ becomes OFF and $Q_{83}$ becomes ON, fixing decoder output X to low level. Therefore, as in the case of Fig. 4, an internal circuit of a memory device is provided which does not operate for responding to a change of address signal for a specified period (T) from a change of address signal and thereby power consumption can be reduced.

In above described embodiments of the present invention internal circuits following decoder circuits are prevented from operating in response to a change of address signal by making operation of the decoder circuits invalid for a specified period after a change of address signal, but is alternatively possible to separately provide for prevention of operation of the other internal circuits following the decoder circuits by taking steps in those internal circuits similar to those taken in decoder circuits in the above-described embodiments.

A memory device embodying this invention does not respond to an unwanted address signal generated in the course of changing of address signals to be input to the memory device, nor does it respond to an unwanted address signal generated by noise on an address signal line, and thereby unwanted power consumption is avoided.

## Claims

1. An asynchronous semiconductor memory device, having a decoder circuit (Fig. 2; Fig. 3: $Q_{20}$, $Q_0$ to $Q_i$) arranged for receiving an address signal (e.g. Ao to A1 or An) and operatively responsive to the address signal, comprising:

a power supply line (Vcc) for supplying an operating voltage, the decoder circuit being arranged for receiving the operating voltage and having an output terminal (X) for outputting a decoded output signal;

a memory cell array (MCA) connected to the decoder circuit for receiving the decoded output signal; and

means (ACD) for detecting changes of the address signal and generating detection output pulses (φ, $\bar{\phi}$),

characterised in that

the detection output pulses (φ, $\bar{\phi}$) have a predetermined pulse width (T) corresponding to a specified period, and the memory device further comprises:

holding means, ($Q_{40}$, $Q_{41}$) for holding the decoder circuit in a not-operating condition for

the specified period after a change in the address signal, the holding means including:

a first transistor (Q40), connected between the power supply line (Vcc) and the decoder circuit, for disconnecting said decoder circuit from the power supply line for the specified period in response to a said detection output pulse, and

a second transistor (Q41), connected to the output terminal of the decoder circuit, for grounding the output terminal for the specified period in response to a said detection output pulse.

2. A device as claimed in Claim 1, wherein the second transistor (Q41) is arranged to respond to a detection output pulse ($\phi$) provided with a polarity the inverse of that of the detection output pulse ($\bar{\phi}$) to which the first transistor (Q40) responds.

**Patentansprüche**

1. Asynchrone Halbleiterspeichervorrichtung, mit einer Decoderschaltung (Fig. 2; Fig. 3; $Q_{20}$, $Q_0$ bis $Q_l$), die zum Empfang von einem Adressensignal (z.B A0 oder A1 oder An) angeordnet ist und wirkungsmäßig auf das Adreßsignal anspricht, mit:

einer Energieversorgungsleitung (Vcc), um eine Betriebsspannung zuzuführen, wobei die Decoderschaltung zum Empfang der Betriebsspannung angeordnet ist und einen Ausgangsanschluß (x) zur Ausgabe eines decodierten Ausgangssignals hat;

einer Speicherzellenanordnung (MCA), die mit der Decoderschaltung verbunden ist, um das decodierte Ausgangssignal zu empfangen; und

Einrichtungen (ACD) zum Detektieren von Änderungen des Adreßsignals und zum Erzeugen von Detektionsausgangsimpulsen ($\phi$, $\bar{\phi}$),

dadurch gekennzeichnet, daß

die Detektionsausgangsimpulse ($\phi$, $\bar{\phi}$) eine vorbestimmte impulsbreite (T) haben, die einer spezifizierten Periode entspricht, und die Speichervorrichtung ferner umfaßt,

Halteeinrichtungen ($Q_{40}$, $Q_{41}$), um die Decoderschaltung für eine bestimmte Periode nach einer Änderung in dem Adreßsignal in einem Nicht-Betriebszustand zu halten, und die Halteeinrichtung umfaßt

einen ersten Transistor ($Q_{40}$), der zwischen der Energieversorgungsleitung (Vcc) und der Decoderschaltung angeschlossen ist, um die genannte Decoderschaltung für eine spezifizierte Periode von der Energieversorgungsleitung zu trennen, in Abhängigkeit von dem genannten Detektionsausgangsimpuls, und

einen zweiten Transistor ($Q_{41}$), der mit dem Ausgangsanschluß der Decoderschaltung verbunden ist, um den Ausgangsanschluß für die spezifizierte Periode zu erden, in Abhängigkeit von einem genannten Detektionsausgangsimpuls.

2. Vorrichtung nach Anspruch 1, bei der der genannte zweite Transistor ($Q_{41}$) angeordnet ist, um auf den Detektionsausgangsimpuls ($\phi$) anzusprechen, der mit einer Polarität versehen ist, welche das Inverse von derjenigen des Detektionsausgangsimpulses ($\bar{\phi}$) ist, auf welchen der erste Transistor ($Q_{40}$) anspricht.

**Revendications**

1. Dispositif de mémoire à semiconducteur asynchrone comportant un circuit décodeur (Figure 2; Figure 3; $Q_{20}$, $Q_0$ à $Q_1$) agencé pour recevoir un signal d'adresse (par exemple Ao ou A1 ou An) et réagissant activement au signal d'adresse, comprenant:

un fil de tension d'alimentation (Vcc) pour fournir une tension d'alimentation, le circuit décodeur étant agencé pour recevoir la tension de fonctionnement et comportant une borne de sortie (X) pour engendrer en sortie un signal de sortie décodé;

une matrice de cellules de mémoire (MCA) connectée au circuit décodeur pour recevoir le signal de sortie décodé; et

un moyen (ACD) pour détecter les changements du signal d'adresse et engendrer des impulsions de sortie de détection ($\phi$, $\bar{\phi}$),

caractériré en ce que

les impulsions de sortie de détection ($\phi$, $\bar{\phi}$) ont une largeur d'impulsion prédéterminée (T) correspondant à une période spécifiée, et le dispositif de mémoire comprend en outre

un moyen de maintien ($Q_{40}$, $Q_{41}$) pour maintenir le circuit décodeur dans un état de non-fonctionnement pendant la période spécifiée après un changement dans le signal d'adresse, le moyen de maintien incluant

un premier transistor (Q40), connecté entre le fil de tension d'alimentation (Vcc) et le circuit décodeur, pour déconnecter le circuit décodeur du fil de tension d'alimentation pendant la période spécifiée en réponse à une impulsion de sortie de détection, et

un deuxième transistor (Q41), connecté à la borne de sortie du circuit décondeur, pour mettre à la masse la borne de sortie pendant la période spécifiée en réponse à une impulsion de sortie de détection.

2. Dispositif selon la revendication 1, dans lequel le deuxième transistor (Q41) est agencé pour répondre à une impulsion de sortie de détection ($\phi$) fournie avec une polarité inverse de celle de l'impulsion de sortie de détection ($\bar{\phi}$) à laquelle le premier transistor (Q40) répond.

Fig. 1

Fig. 2

Fig. 3A

A₀ ~P

Fig. 3B

A₁

Fig. 3C

Az

Fig. 3D

"a" "c" "b" "d" "b"

Fig.3E

Xa

Fig.3F

Xc

Fig.3G

Xb

Fig.3H

Xd

Fig. 4

Fig. 5A

Fig. 5B

Fig. 5C

Fig. 5D

Fig. 5E

Fig. 5F

3

Fig. 6

Fig. 7

Fig. 8